# EUROPEAN PATENT APPLICATION

(11) **EP 2 099 077 A1**
(43) Date of publication of application: **09.09.2009**
(21) Application number: 08004164.3
(22) Date of filing: 06.03.2008
(51) Int. Cl.: H01L 31/042, H01L 31/048, F24J 2/52

(54) **Module for converting solar radiation into electricity**

(71) Applicant: Inventux Technologies AG, 12681 Berlin (DE)
(72) Inventor: Sillmann, Roland, 13156 Berlin (DE); Cramer, Christine, 32791 Spenge (DE); Häger, Andreas, 32139 Spenge (DE); Ronge, Thorsten, 10243 Berlin (DE)
(74) Representative: Grünecker, Kinkeldey, Stockmair & Schwanhäusser Anwaltssozietät

(57) **Abstract**

The invention relates to a module for converting solar radiation into electricity comprising: a panel (3) having a front (5) and a back (7) main side, with a solar energy converting means (11) arranged on or in the front main side and a means for fixing (15) the module to an object. In order to allow a mounting that prevents accumulation of dirt in the edge region of the panel the means for fixing (15) the module is furthermore arranged over the back (7) main side of the panel (3) and away from the edges (17a-17d) of the panel (3). The invention furthermore relates to a fixing device configured to receive such a module and to a combination of a module and a fixing device.

## Description

The invention relates to a module for converting solar radiation into electricity comprising a panel with a first and second main side, wherein solar energy converting means are arranged on or in the first main side of the panel and, furthermore, comprising a means for fixing the module to an object.

In such modules the solar radiation converting means are encapsulated to render the solar radiation converting means, for example in the from of crystalline solar cells or substrates with thin light absorbing layers, resistant against harmful environmental conditions and to satisfy the static requirements necessary for fixing the modules to an object, like the roof or wall of a building or directly greenfield.

A first kind of solar modules present on the market comprises a front layer, a solar radiation-converting layer (also called active layer), an adhesive layer and a backside plastic film. This type of layer structure does not yet satisfy the static requirements and is thus provided with a metal frame, typically out of aluminum, to provide the necessary mechanical stability. Due to this metallic frame, this kind of module becomes expensive.

A second kind of module, which is particularly applied to thin film solar modules, comprises a front glass layer, a thin solar radiation converting layer (also called the active layer), an adhesive layer and a backside glass layer. Compared to the first kind of module, no metallic frame is necessary as the back glass plate provides the necessary mechanical stability. As a consequence, cheaper modules can be fabricated.

Nevertheless also this kind of module represents disadvantages. To fix the module to an object four metallic clamps are attached to the edge region of the solar module (two on each side) by sandwiching the module in between the two legs of each clamp. The clamps furthermore provide the possibility to fix the module to a suitable frame using bolts.

The use of clamps in the technology without a metallic frame has however, the following problems. First of all, to prevent corrosion effects, it is mandatory that the metallic clamps are electrically isolated from the module, which renders the design of the clamps more complicated and thus more expensive.

Second, the mounting of the module at four points leads to a high, localized mechanical stress level under static load arising, for example, under windy conditions. These locally important stress peaks lead to a damaging of the module. To counter this negative effect, the glass plates, in particular the backside glass layer, need to have an important thickness and have to be hardened, like a so called TVG glass with 6 to 8mm thickness. This leads to an increase in weight, which in turn leads not only to higher fabrication costs but also to a more difficult mounting of the modules.

In addition, the region where the clamps are to be fixed is free from solar radiation transforming means, thereby reducing the efficiency per m² as not the total surface of the panel can be used to obtain electricity.

Finally, the accumulation of dirt usually accompanied by the presence of humidity in the vicinity of the clamps, which protrude slightly above the surface plane of the solar module, has a negative impact on the lifecycle of the modules. In fact, the edge region of the laminate represents the weakest region of the laminate, as humidity can enter via the layer interfaces and damage the active layer by corrosion.

It has been proposed to provide a clamping mechanism, which uses clamps screwed to the edge of the panel and on the backside thereof. These clamps project laterally over the edge of the panel so that the panel can be fixed. Also with this kind of solution, the problem of dirt accumulation occurs and furthermore also high localized mechanical stress. In addition, the protruding parts make the overall surface area of the panel larger, which raises transportation costs. Finally the fixed position of the clamp renders the fixing of the module to a frame rather difficult.

To cope with these requirements, the known products either provide expensive aluminum frames or thick glass layers together with complicated clamps. Finally, the accumulation of dirt remains an unsolved problem.

It is therefore the object of the present invention to provide a module for converting solar radiation into electricity which overcomes the abovementioned problems, is cheaper to fabricate, easier to mount and provides a longer lifecycle.

This object is achieved with the module for converting solar radiation into electricity according to claim 1. Accordingly, the module for converting solar radiation into electricity comprises a panel with a first and second main side, wherein a solar radiation converting means is arranged on or in the first main side and a means for fixing the module to an object.

According to the invention, the means for fixing the module is arranged over the back main side of the panel and with a clearance with respect to the edge.

By providing the means for fixing the module over, in particular on, the back main side of the panel and away from the edge, there is no need to provide special isolating means to electrically isolate the means for fixing from the edge side walls of the panel as any electrical contact between the means for fixing and the active radiation converting means can be prevented due to the special geometrical arrangement, which keeps fabrication costs low. Furthermore, by providing a clearance between the edge region of the panel and the fixing means, any dirt which could eventually accumulate at or near the means for fixing the module can not reach the weak spot of the panel, namely the edge region, so that a corrosion of the solar radiation converting means can be prevented, at least to a large extent. Thus, with the inventive module the lifecycle of the module can be improved.

In this context "over" means that the means for fixing is either directly provided on the back side of the panel or on the back side of any additional layers, e.g. spacers or reinforcement members, that could be provided on the backside of the panel. Furthermore, the term "clearance" means that the means for fixing is spaced away from the edges of the panel. In addition, providing the solar radiation energy converting means on or in the front main side corresponds to an arrangement in which the solar radiation energy converting means are such that it can be reached by the solar radiation.

Preferably, the distance between the edge and the means for fixing can be at least 1 cm, in particular more than 5 cm. Dirt accumulation in the vicinity of the edge region can be prevented for a clearance value in this value range.

According to a variant, the means for fixing is configured such that, when seen from above, it is completely positioned inside the external contour of the panel. Therefore the fixing means is invisible, when the module is mounted.

Preferably, the means for fixing can be oblong and, in particular, extend over a range of about 20 - 95%, in particular 50 - 90% of the longest dimension of the panel of the module. By providing a fixing means that extends over a large surface area, a high stress load which might occur under windy weather conditions, can be distributed over a large part of the panel and thereby damage to the panel can be prevented.

According to a variant, the means for fixing can be oblong and, in particular, extend over a range of about 20 - 95%, in particular 50 - 90% of the smaller dimension of the panel of the module. By providing a fixing means that extends over a large surface area, a high stress load which might occur under windy weather conditions, can be distributed over a large part of the panel and thereby damage to the panel can be prevented.

Advantageously, the means for fixing the module can be attached to the back main side of the panel by gluing. Gluing has the advantage that the panel itself does not need to be damaged to achieve fixing. Furthermore the process can be realized in an automated way. Finally, gluing provides a reliable long lasting connection between the two parts. Even more preferred is an attachment by gluing, for which an elastic connection between the two parts - panel and means for fixing - is achieved which will be able to attenuate deformations.

Preferably, the means for fixing the module can comprise at least one profile, in particular an u-shaped metal profile or a z-shaped metal profile. In case of a u or z-shaped profile, the surface of one leg can be used to attach the means for fixing of the module to the panel and the other leg can be used to attach the module to the object, by e.g. using clamps, screws etc.

The object of the invention is also achieved with the module according to claim 7. This module for converting solar radiation into electricity comprises a panel with a front and back main side, wherein solar radiation converting means are arranged on or in the front main side and a means for fixing the module to an object on the back side of the panel. The means for fixing the module is furthermore configured to mechanically engage with a fixing device of the object by a clamp connection. This module can be combined with any one of the features of the module as already described above individually or in combination.

A clamp connection has the advantage that no additional parts or pieces are necessary to achieve the fixing of the module with the fixing device and, thus, facilitates the mounting of the module. The frictional forces between the means for fixing and the fixing device are sufficient to keep the module in place.

Preferably, the means for fixing the module can be configured to engage by snapping into the fixing device. Such a snapping-in further prevents an unwanted displacement of the module with respect to the fixing device, as in addition to frictional forces also mechanical forces prevent a movement. The module can be configured to prevent movement by snapping-in in one or more directions. Preferably the snap-in connection is realized such that a release of the connection can be achieved.

Preferably, the means for fixing can comprise a tongue with a projection for snapping into a corresponding recess in the fixing device. This further serves to stabilize the connection between module and fixing device. According to a variant, the projection and the recess could be configured such that e.g. using an undercut in the recess and corresponding hook-like projection, an unwanted release can be prevented. This feature can thus be used as an anti-theft measure.

Advantageously, the tongue can be flexible. This feature facilitates a relative movement between the fixing means and the fixing device and enables a release of the connection if necessary, e.g. to exchange a defective module.

The means for fixing can advantageously comprise a first means having a first groove, in particular an u-shaped profile and a second means having a second groove, in particular an u-shaped profile, wherein the first and second groove face in opposite directions. In this context the direction attributed to a groove corresponds to the surface normal of the opening of the grooves and which directs towards the outside of the groove away from the corresponding means.

Preferably at least one means can furthermore comprises a tongue with a projection.

According to a preferred embodiment, the panel can comprise a front layer, an active layer, and a back side layer, at which the means for fixing the module is arranged. In this context, the active layer comprises the solar energy converting means which are for example deposited in the form of thin films onto the front layer. Typically an adhesive layer is provided to attach the back side layer to the other layers. Nevertheless, the active layer could also be provided on the back side layer and this structure is then attached to a front layer. Thus, even a solar module having a laminated structure without a metal frame can thus be easily fixed to an object without the negative effects as described above. Furthermore, with the same thickness of the structure, the module can be used under harsher conditions compared to the above described laminate module, as the static load the module according to the invention can support is at least up to a factor two better.

Advantageously, the front and/or back side layer can be out of glass, in particular non hardened float glass, and can have a thickness of less than 5mm, in particular less than 3,5, more in particular of 3 or 3.2mm. Compared to the solar modules on the market, a thinner glass layer can be used for the same static load conditions, as the fixing means on the back side releases the mechanical requirements of the module by at least up to about a factor two compared to the fixing clamps used in the known devices. With the released mechanical requirements, it becomes even possible to use plastic sheets or foils instead of the glass layer. This advantage is particularly important for standard modules with a size of 1100mm*1300mm, as the weight reduction is important.

The object of the invention is also achieved with the fixing device for receiving a module for converting solar radiation into electricity like described above. This fixing device comprises a profile with a groove configured to receive the means for fixing the module of the module for converting solar radiation into electricity. In the embodiment realizing a clamping connection between the fixing device and the solar module, the especially adapted profile of the fixing device allows for a safe and easy mounting of the module on the fixing device of the object, without the necessity of additional means, like bolts etc.

Advantageously, the profile has a groove configured to at least partially receive the projection of the tongue of the means for fixing of the module. In this configuration, a snap-in connection (click-in) is realized which prevents a relative displacement of the module with respect to the fixing device at least along one direction.

Preferably, the fixing device can comprise a first fixing means comprising a first fixing groove and second fixing means comprising a second fixing groove, in particular u-shaped profiles, wherein the first and second fixing grooves are faxing into opposite directions.

The invention also relates to a combination comprising at least one module as described above as well as at least one fixing device as described above, wherein the means for fixing of at least one module is in clamp connection with the fixing device. The clamp connection allows for a reliable and easy connection between the module and the fixing device without additional fixing means and can, at the same time, be configured such that the connection is releasable in case, for example, a broken module needs to be exchanged.

Advantageously the clamp connection extends essentially over the entire length of the means for fixing. Thus, forces, which are transferred via the connection, are distributed over a large surface and thus high stress levels on the panel can be prevented.

The invention also relates to a method for mounting a module as described above on a fixing device as described above and which comprises the steps of: providing the fixing device, providing the module and mechanically engaging the means for fixing the module with the fixing device using a clamp-connection. This method is easy to carry out, as no further tools are mandatory.

Preferably the means for fixing can comprise a first means having a first groove, in particular an u-shaped profile and a second means having a second groove, in particular an u-shaped profile, wherein the first and second groove face in opposite directions and the fixing device comprises a first fixing means comprising a first fixing groove and second fixing means comprising a second fixing groove, in particular u-shaped profiles, wherein the first and second fixing grooves are facing into opposite directions, wherein the last step comprises: introducing a lower leg of the second means into the first fixing groove, then introducing a lower leg of the first means into the second fixing groove, in particular by sliding, while the lower leg of the second means remains in the first fixing groove.

Advantageously the method can further comprise a step of snapping a projection on the lower leg of the first means into a corresponding recess in the first fixing means.

Advantageous embodiments of the invention will be described in detail in combination with the enclosed Figures:
- Figure 1: illustrates a three dimensional view of a module for converting solar radiation into electricity according to a first embodiment of the invention,
- Figure 2a: illustrates the module for converting solar radiation according to the first embodiment attached to a fixing device thereby forming a second embodiment,
- Figure 2b: is a partial side cut view of the module attached to the fixing device,
- Figure 3a: illustrates a partial side cut view of a third embodiment of the invention,
- Figure 3b: illustrates the third embodiment in a mounted state,
- Figure 4a: illustrate a partial side cut view of a fourth embodiment of the invention at a first mounting step,
- Figure 4b: illustrates the fourth embodiment during a second mounting step, and
- Figure 4c: illustrates the fourth embodiment in a mounted state, and
- Figure 5: illustrates a sixth embodiment of the invention.

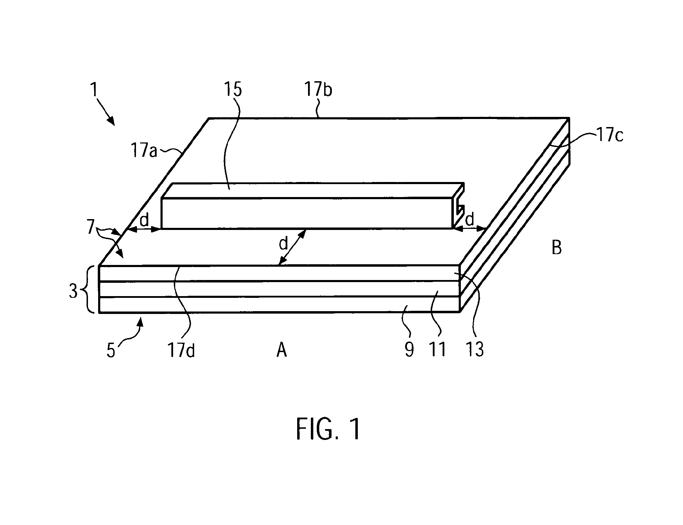

Figure 1 illustrates a module 1 for converting solar radiation into electricity according to the invention. The module 1 comprises a panel 3 with a front main side 5 and a back main side 7. The panel 3 itself is a laminate comprising a front layer 9, an active layer 11 comprising solar energy converting means and a back layer 13. In this embodiment both the front layer 9 and the back layer 13 are out of glass. The active layer in this embodiment is a thin layer deposited on the front glass layer 9. The back side layer 13 is attached to the active layer 11 via an adhesive layer. The invention is nevertheless not limited to thin film solar modules. Furthermore, a means 15 for fixing the module 1 to an object (not shown) is attached to the back side 7 of panel 3.

The panel 3 in this embodiment is rectangular, however, other forms or even curved surfaces are possible. Panel 3 represents a standard panel with a surface area of 1100mm*1300mm.

In this embodiment, the means 15 for fixing the module 1 is glued to the back main side 7 of panel 3. Gluing ensures a simple but reliable connection with the back side of the panel 3 and its implementation into a fabrication process is easily achieved.

The means 15 for fixing the module of this embodiment is an oblong metal profile in a u-shape. Instead of the u-shape, other suitable profile shapes could be used, like for example a z-shape etc... The legs of the u-shaped profile here have the same length, which is, however, not mandatory. Figure 1 illustrates the presence of only one metal profile made out of one piece. The invention is, however, not limited to providing only one profile 15 on the back main side of panel 3 but, depending on the requirements concerning mechanic stability, two or more profiles could be provided on the back side 7 of the panel 3 which are arranged in parallel or not. Furthermore Figure 1 shows a profile made out of one piece, instead the means 15 for fixing could also be made out of a plurality of shorter profiles arranged in line, to allow for example air or water to pass through. Alternatively clearances might be provided in the profile to achieve the same effect.

The metal profile 15 is preferably arranged essentially parallel to one of the edges 17a - 17d of the panel 3, here along the longer side A (edge 17b, 17d). It could of course also be arranged in parallel with respect to the short side B (edge, 17a, 17c) of the panel 3. Other geometries are also possible without delimiting the application, like for example slanted with respect to the edges 17a-17d.

According to the invention, the means for fixing the module 15 is attached to the back side 7 of the panel 3 such that it is arranged away from the edges 17a - 17d by a clearance d. Preferably, the clearance "d" with respect to each one of the edges 17a -17d of the panel 3 is at least 1 cm.

Preferably, the means 15 for fixing the module extends over at least 20% up to about 95% of either length "A" or width "B" of the panel 3 depending on whether the profile is arranged in parallel to the length "A" or in parallel to the length "B".

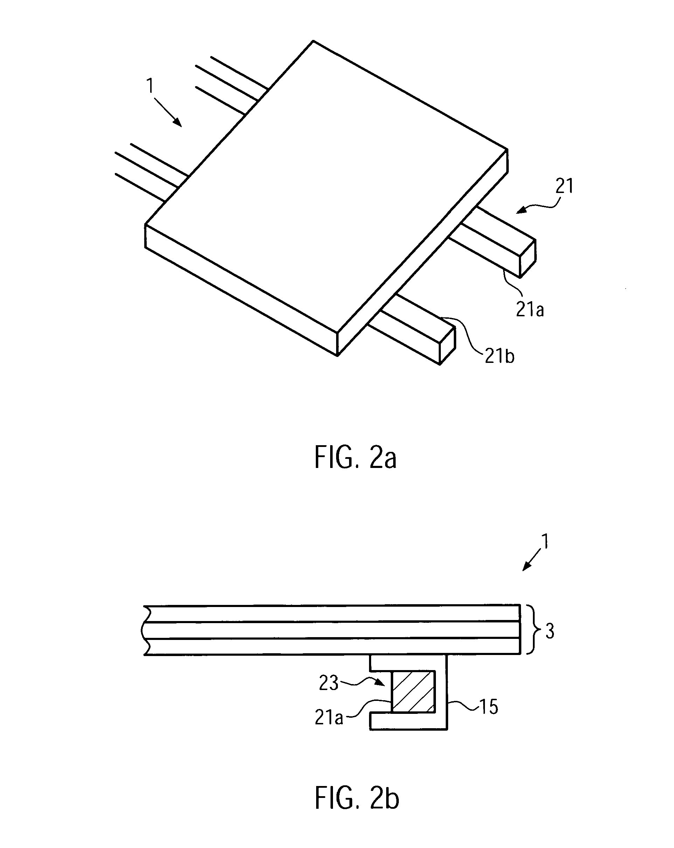

Figure 2A illustrate module 1 mounted on a fixing device 21 which in turn could be attached to a roof or a wall of an object, for example of a house or building, or directly attached to a free-standing frame not shown in Figure 2A. The fixing device comprises a set of profiles 21 a and 21b, which are essentially arranged in parallel and form a supporting area for module 1.

Figure 2B is a partial side-cut view of Figure 2A illustrating how the mounting to the fixing device 21 is achieved with a means for fixing 15 according to the invention. The module 1 is actually held in place by inserting, at least partially, the profile 21 a of the fixing device 21 into recess 23 of the u-shaped profile of the means for fixing 15 which forms a groove.

According to one variant of the embodiment, the cross section of profile 21 a could be chosen such that the frictional forces between the profile 21 a and the means for fixing 15 is sufficient to prevent an unintentional relative movement of the panel 3, thereby achieving a clamp connection. According to another variant the contact surface between the profile 21 a and the means for fixing 15 can be chosen such that a movement perpendicular to drawing plane is still possible which would facilitate the alignment of the panel 3 with respect to additional panels already in place.

The combination out of module 1 and fixing device 21 form a second embodiment according to the invention.

To prevent a relative movement between module 1 and the fixing device 21, further securing means, like bolts or any other locking means, can be provided in addition.

With a module 1 according to the invention, the following advantages can be achieved with respect to prior art modules like described above.

Due to the fact that the means 15 for fixing the module are arranged on the back side 7 only of the panel 3 and furthermore spaced apart from the edges 17a - 17d of the panel 3, dirt, snow, etc.. which might accumulate in the transitional region between the panel and the means for fixing cannot reach the edge region 17a-17d of the panel which represents the weakest points of such a laminate. Thus, water or other harmful elements, which might enter at the interfaces of the panel 3 and deteriorate or destroy the solar radiation converting means by corrosion is prevented from entering into the laminate.

In addition, by providing an oblong profile 15, a connection with an object can be realized over a large surface such that stress which could for example occur during bad weather conditions with high winds, does not lead to excessive stress peaks at limited locations on the panel, like for example in prior art modules using clamps at the edge to mount. Thus the static requirements can be released such that thinner front and/or back layers can be used in the modules, which render the modules cheaper and their weight becomes reduced. Thus, according to a variant of the embodiment of the invention, glass layers with less than 5mm, in particular less than 3,5 mm, more in particular of 3,2mm or 3mm of normal float glass are used.

Finally, by arranging the means for fixing 15 on the back side only, no particular measures need to be taken to electrically isolate the means for fixing 15 from the edge region 17a to 17d, which is mandatory in the known fixing methods using clamps which have to be arranged on the edge of a module.

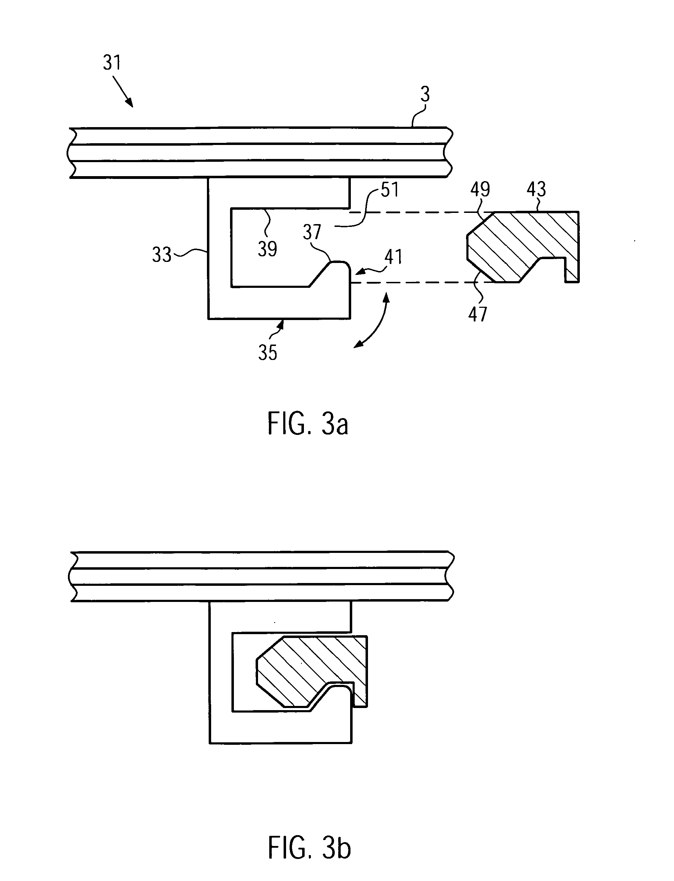

Figures 3a and 3b illustrate a third embodiment according to the invention. Features with reference numerals already used for the description of the first embodiment will not be explained in detail again, but their description is incorporated herewith by reference.

The left hand side of figure 3a represents a partial cross cut view of a panel 31 with a second kind of means for fixing 33 the module which is attached, e.g. by gluing to a panel 3, comparable to the illustration of Figure 2a. The difference between the means for fixing 33 and the means for fixing 15 of the first embodiment is that the lower leg 35 of the u-shaped profile is flexible as indicated by the arrows and forms a tongue with a projection 37 towards the free extremity 41 of the lower leg 35. The projection 37 in this embodiment is directed towards the first leg 39 of the profile.

The projection 37 can be present over the entire length of the lower leg 35 in the direction perpendicular to the drawing plane, or could only be present at one or more locations along the lower leg 37. Furthermore, Figure 3a shows the projection 37 at the extremity 41, however, the projection 37 could also be arranged with a certain distance with respect to the extremity 41. In addition, the lower leg 35 can be longer or shorter compared to the upper leg 39. The projection 37 and the profile of the means for fixing 33 here are made out of the same work piece. Nevertheless projection 37 could also be a separate piece out of a different material and attached to the lower leg 35.

The right hand side of Figure 3a illustrates the cross section of a profile 43 of a fixing device, like illustrated in Figure 2a, which has the same properties as profile 21 a, 21b with the difference being that profile 43 has a recess portion 45 the shape of which is adapted to receive at least partially, preferably completely, the projection 37 of the fixing means 33. The recess portion 45 can be arranged over the entire length of the profile thus forming a groove.

Furthermore the profile 43 has beveled portions 47 and 49 on the side of the profile, which will enter recess 51 of the u-shaped profile 33.

The projection 37 and the recess portion 45 are arranged such that when the module 1 is mounted onto the fixing device, a snap-in connection between the means for fixing 33 and the profile 43 of the fixing device can be achieved. This situation is illustrated in Figure 3b.

The beveled portions 47 and 49 serve to facilitate the bending of the lower leg 35, such that when approaching the module 1 and the fixing device with respect to each other, the projection 37 can be moved out of the way of the profile 43, such that the desired clamp- and snap-in connection between the two is achieved.

In this way a connection between the two elements is achieved that securely locks the module 1 in place, but that can still be released if necessary, by bending down the lower leg 35. To prevent an accidental releasing of the connection additional fixing or securing means like mentioned with the first embodiment can be used. To prevent theft, according to a variant of this embodiment, the recess 45 can have an undercut region and the projection 37 a hook like form. In this case it is more difficult to release the connection.

With the module according to the third embodiment and the fixing device and their combination the same advantageous effects like for the first and second embodiment can be achieved.

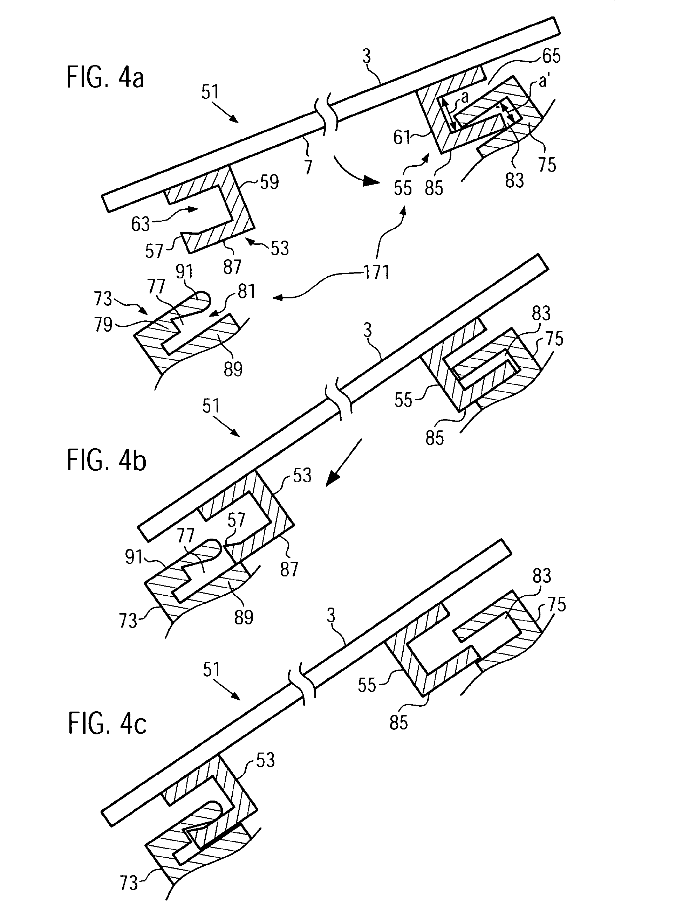

Figures 4a to 4c illustrate a cross cut view of a fourth embodiment of the invention. Again features with reference numerals already used for the description of the first to third embodiment will not be explained in detail again, but their description is incorporated herewith by reference. The solar module 51 comprises a panel 3 and attached to its backside 7 two u-shaped profiles 53 and 55 playing the role of the means for fixing which are arranged in parallel. The left profile 53 has the shape of the means for fixing 33 of the second embodiment with a projection 57 at the lower leg and directed towards the upper leg. The right profile 55 has the shape of the means for fixing 15 of the first embodiment. Furthermore the base 59 and the base 61 of the u-shaped profiles 53 and 55 are facing each other such that the recesses 63 and 65 are facing in opposite directions and do not face each other - the openings thus face outwardly.

With this structure a simple but safe mounting to a frame of fixing device 71 comprising a first and second fixing profile 73 and 75. Like profiles 53 and 55, also the fixing profiles 73 and 75 are u-shaped and profile 73 furthermore comprises a recess portion 77 at the upper leg 79, which is adapted to the projection 57 of profile 53. Unlike profiles 53 and 55, the fixing profiles 73 and 75 of the fixing device 71 have their recesses 81 and 83 facing each other - thus the openings face inwardly.

To fix the module 51 to fixing profiles 73 and 75 of the fixing device 71, first of all the lower leg 85 of the right u-profile 55 is introduced into recess 83 of the fixing profile 75. To facilitate the introduction of the lower leg 85 the widths a, a' of the base 61 and base 87 of the fixing profile 75 inside the recesses 65 and 83 is larger than the one of the lower legs 75 and 85 such that the introduction can be achieved under an angle α (see Figure 4a).

Then module 51 is angled down and the lower leg 87 of profile 53 comes to a rest on the lower leg 89 of the left fixing profile 73. This is achieved, as in this embodiment the lower leg 89 of the fixing profile 73 is longer than the upper leg 91. Furthermore the distance between the profiles 53 and 55 on the one hand and the fixing profiles 73 and 75 is such, that the lower leg 85 of the right profile 55 is still positioned in the recess 83 of the fixing profile 75, like shown in Figure 4b. Now, a sliding of module 51 on the upper surfaces of the lower legs 89 and 75 is still possible. A movement perpendicular to the drawing plane would allow to align the module 51 with respect to other modules already mounted (see Figure 2a) and a movement in the plane, supported by the gravitational force, will allow the fixing of the module 51 by clicking of the projection 57 into recess 77 to prevent a further movement in this direction. This situation is illustrated in Figure 4c. The connection between the left fixing profile 73 and the left profile 53 is preferably based on frictional forces between the legs of the u-shaped profiles and mechanical forces due to snapping-in. On the right hand side the lower leg 85 of profile 55 is still positioned in the recess 83 of the right fixing profile 75. This prevents a tilting of panel 3.

Of course the position of profiles 53 and 55, as well as the position of the fixing profiles 73 and 75 can be exchanged. In this case, one would have to move the panel 51 against gravitational forces to bring let it snap into recess 77.

Module 51 and fixing device 71 form the fifth embodiment of the invention. The fourth and fifth embodiment share all the advantages as previously described with respect to embodiments 1 to 3. It is furthermore important to mention that the advantages of the clamp connection and or the click-in (snap-in) connection can also be achieved with modules in which the means for fixing extends over the backside without clearance to the edge. Nevertheless in this case the problem of dirt accumulation remains.

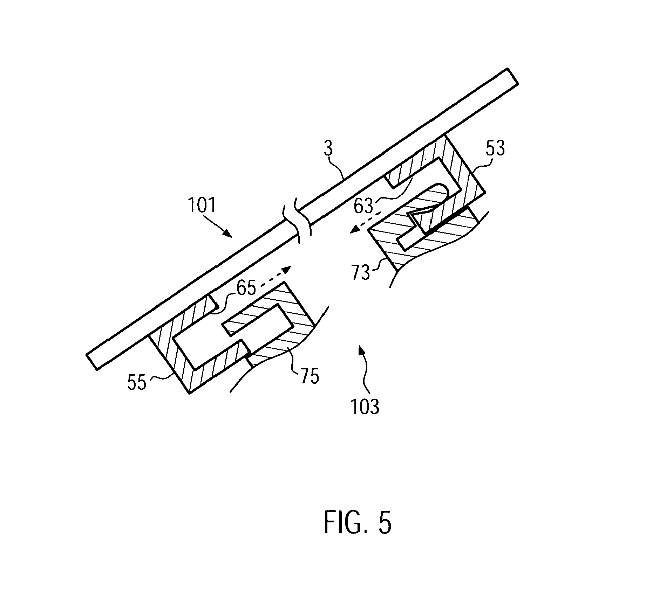

Figure 5 illustrates a module 101 according to a sixth embodiment of the invention. The only difference with respect to the module 51 of the fourth embodiment is that the position of the profiles 51 and 53 are inverted. Now the recesses (grooves) 65 and 63 are facing each other, but are still facing in opposite directions (as indicated by arrows). Accordingly also the fixing device 103 comprises the fixing profiles 73 and 75 as illustrated in Figures 4a and 4c, however also with inverted positions. The distance between the two fixing profiles 73 and 75 is also reduced to take into account the change of the direction of the openings of the recesses 65 and 63.

The combination of module 101 and fixing device 103 form a seventh embodiment.

The features of the various embodiments 1 to 7 can be freely combined to achieve further advantage variants according to the invention.

## Claims

1. Module for converting solar radiation into electricity comprising:
- a panel (3) having a front (5) and a back (7) main side, with a solar energy converting means (11) arranged on or in the front main side and
- a means for fixing (15) the module to an object
**characterized in that**
the means for fixing (15) the module is arranged over the back (7) main side of the panel (3) and with a clearance with respect to the edges (17a-17d) of the panel (3).

2. Module according to claim 1, wherein the distance (d) between the edge (17a-17d) and the means for fixing (15) the module is at least 1 cm, in particular more than 5cm.

3. Module according to one of claims 1 or 2, wherein the means for fixing (15) is oblong and in particular extends over a range of about 20 to 90%, in particular 50 to 90%, of the longest dimension of the panel (3) of the module.

4. Module according to one of claims 1 or 2, wherein the means for fixing (15) is oblong and in particular extends over a range of about 20 to 90%, in particular 50 to 90%, of the smaller dimension of the panel (3) of the module.

5. Module according to one of claims 1 to 4, wherein the means for fixing (15) the module is attached to the back main side of the panel (3) by gluing.

6. Module according to one of claims 1 to 5, wherein the means for fixing the module (15) comprises at least one profile, in particular an u-shaped metal profile or a z-shaped metal profile.

7. Module, in particular according to one of claims 1 to 6, for converting solar radiation into electricity comprising a panel (3) having a front (5) and a back (7) main side, wherein solar radiation converting means (11) are arranged on or in the front (5) main side and a means for fixing (15) the module to an object on the back (7) side of the panel (3), wherein the means for fixing (15) the module is configured to mechanically engage with a fixing device (21) of the object by a clamp-connection.

8. Module according to claim 7, wherein the means for fixing the module (15) is configured to engage by snapping into the fixing device (21).

9. Module according to claim 8, wherein the means for fixing (15) comprises a tongue with a projection for snapping into a corresponding recess in the fixing device (21).

10. Module according to claim 9, wherein the tongue is flexible.

11. Module according to one of claims 7 to 10, wherein the means for fixing (15) comprises a first means (53) having a first groove (63), in particular an u-shaped profile and a second means (55) having a second groove (65), in particular an u-shaped profile, wherein the first and second grooves (55, 65) face in opposite directions.

12. Module according to claim 11, wherein at least one means furthermore comprises a tongue (87) with a projection (57).

13. Module according to one of claims 1 to 12, wherein the panel comprises a front layer (9), an active layer (11) and a backside layer (13), at which the means for fixing (15) the module is arranged.

14. Module according to one of claims 13, wherein the front layer (9) and/or backside layer (11) is/are out of glass and has/have a thickness of less than 5mm, in particular less than 3,5mm, even more in particular 3,2 or 3mm.

15. Module according to claim 14, wherein the panel has a size of 1100mm * 1300mm.

16. Module according to claim 14 or 15, wherein the glass is float glass.

17. Fixing device for receiving a module for converting solar radiation into electricity according to one of claims 1 to 16, comprising a profile with a groove configured to receive the means for fixing the module of the module.

18. Fixing device according to claim 17, wherein the profile has a groove configured to at least partially receive the projection of the tongue of the means for fixing of the module.

19. Fixing device according to claim 17 or 18, comprising a first fixing means (73) comprising a first fixing groove (81) and second fixing means (75) comprising a second fixing groove (83), in particular u-shaped profiles, wherein the first and second fixing grooves are facing into opposite directions.

20. Combination comprising at least one module according to one of claims 1 to 16 and a fixing device according to one of claims 17 to 19, wherein the means for fixing of at least one module is in a clamp-connection with the fixing device.

21. Combination according to claim 20, wherein the clamp-connection extends essentially over the entire length of the means for fixing.

22. Combination according to claim 20 or 21, wherein the first groove (63) and the second fixing groove (81) face in the same direction, and wherein the second groove (65) and the first fixing groove (83) face in the same direction.

23. Method for mounting a module according to one of claims 1 to 16 on a fixing device according to one of claims 17 to 19, comprising the steps of:
a) providing the fixing device
b) providing the module'
c) mechanically engage the means (15) for fixing the module with the fixing device using a clamp-connection.

24. Method according to claim 23, wherein the means for fixing (15) comprises a first means (53) having a first groove (63), in particular an u-shaped profile and a second means (55) having a second groove (65), in particular an u-shaped profile, wherein the first (63) and second (65) groove face in opposite directions and the fixing device (71) comprises a first fixing means (73) comprising a first fixing groove (81) and second fixing means (75) comprising a second fixing groove (83), in particular u-shaped profiles, wherein the first and second fixing grooves are facing into opposite directions, wherein step c) comprises:
c1) introducing a lower leg (85) of the second means (55) into the first fixing groove (83), then
c2) introducing a lower leg (87) of the first means (53) into the second fixing groove, in particular by sliding, while the lower leg (87) of the second means (55) remains in the first fixing groove (83).

25. Method according to claim 24, further comprising a step c3) of snapping a projection (57) on the lower leg (87) of the first means into a corresponding recess (77) in the first fixing means (13).
